# EUROPEAN PATENT APPLICATION

(11) **EP 4 456 329 A1**
(43) Date of publication of application: **30.10.2024**
(21) Application number: 23216334.5
(22) Date of filing: 13.12.2023
(51) Int. Cl.: H01Q 21/20, H01Q 1/22, H01L 23/66

(54) **SPHERICAL ANTENNA ARRANGEMENT WITH Z-DIMENSIONAL PLATED ANTENNA STRUCTURES**

(30) Priority: 27.04.2023 US 202318140346
(71) Applicant: INTEL Corporation, Santa Clara, CA 95054 (US)
(72) Inventor: WAGNER, Thomas, 91189 Regelsbach (DE); SEIDEMANN, Georg, 84036 Landshut (DE); YANG, Tae Young, Portland, 97229 (US); GOSSNER, Harald, 85521 Riemerling (DE); KAMGAING, Telesphor, Chandler, 85249 (US); WAIDHAS, Bernd, 93186 Pettendorf (DE)
(74) Representative: 2SPL Patentanwälte PartG mbB

(57) **Abstract**

Embodiments disclosed herein include a communication module. In an embodiment, the communication module comprises a package substrate, and a die on the package substrate. In an embodiment, a plurality of antennas are around the die. In an embodiment, the plurality of antennas are coupled to the die by a plurality of traces, and heights of each of the plurality of antennas is greater than a thickness of the traces.

## Description

### TECHNICAL FIELD

Embodiments of the present disclosure relate to electronic systems, and more particularly, to electronic packages with spherical antenna arrangements with Z-dimensional plated antenna structures.

### BACKGROUND

Antenna in package (AiP) designs typically include an array of square antennas or other two-dimensional shape antennas on the top of a package substrate. With a two-dimensional approach, one of the challenges to overcome is the unequal distance of the output driver (e.g., a transceiver) to the dedicated antenna area. Further, two-dimensional solutions typically emit and receive electromagnetic radiation in the Z-direction. As such, beam forming techniques may be needed in order to improve communication with external devices. Additionally, planar two-dimensional patch antenna arrays require larger package and/or die form factors.

In one approach, the AiP is split into several sub modules, and the sub modules are placed in various X, Y, and Z directions to optimize the radiation direction. However, several placement locations for the AiP increases the cost and complexity due to the more complex interconnect architecture that is needed. In other solutions, three-dimensional structures can be used for the antennas. However, three-dimensional shapes require special three-dimensional surface processes, which lead to significantly higher costs.

### BRIEF DESCRIPTION OF THE DRAWINGS

Figure 1 is a plan view illustration of an electronic package with an array of two-dimensional patch antennas coupled to a transceiver.
Figure 2 is a plan view illustration of an electronic package with a transceiver with an array of antennas arranged in a circular pattern around the transceiver, in accordance with an embodiment.
Figure 3A is a cross-sectional illustration of a portion of a package with a three-dimensional (3D) antenna structure, in accordance with an embodiment.
Figure 3B is a cross-sectional illustration of a portion of a package with a 3D antenna structure with non-vertical sidewalls, in accordance with an embodiment.
Figures 4A-4F are cross-sectional illustrations depicting a process for forming a 3D antenna structure, in accordance with an embodiment.
Figure 5 is a cross-sectional illustration of an electronic package with a 3D antenna structure that has a parabolic shape, in accordance with an embodiment.
Figure 6A is a cross-sectional illustration of an electronic package with 3D antennas that are coupled to a transceiver, in accordance with an embodiment.
Figure 6B is a cross-sectional illustration of an electronic package with 3D antennas that are on an opposite side of the package substrate from the transceiver, in accordance with an embodiment.
Figure 7A is a plan view illustration of an electronic package with 3D antennas provided in a circular pattern and an array of two-dimensional (2D) patch antennas, in accordance with an embodiment.
Figure 7B is a plan view illustration of an electronic package with 3D antennas and 2D patch antennas, in accordance with an embodiment.
Figure 8 is a cross-sectional illustration of an electronic system with a package that includes 3D antenna architectures, in accordance with an embodiment.
Figure 9A is a cross-sectional illustration of a die with a 3D antenna that emits electromagnetic radiation in a plane parallel to the X-Y plane, in accordance with an embodiment.
Figure 9B is a plan view illustration of a die with 3D antennas that emit electromagnetic radiation in planes parallel to X-Y plane, in accordance with an embodiment.
Figure 9C is a cross-sectional illustration of a die with a 3D antenna that emits electromagnetic radiation in a plane parallel to the X-Y plane and a 2D antenna that emits electromagnetic radiation in the Z-direction, in accordance with an embodiment.
Figure 10A is an illustration of a die with 3D antennas provided in a ring around the die, in accordance with an embodiment.
Figure 10B is an illustration of a die with different 3D antenna architectures, in accordance with an embodiment.
Figure 10C is an illustration of 3D antennas that are isolated from each other by a 3D isolation feature, in accordance with an embodiment.
Figure 10D is an illustration of 3D antennas that are isolated from each other by a 3D ring isolation feature, in accordance with an embodiment.
Figure 11A is a cross-sectional illustration of an electronic package with a 3D antenna on a die, in accordance with an embodiment.
Figure 11B is a cross-sectional illustration of an electronic package with a 3D antenna on a die, in accordance with an additional embodiment.
Figure 12 is a cross-sectional illustration of an electronic system with a 3D antenna on a die, in accordance with an embodiment.
Figure 13 is a schematic of a computing device built in accordance with an embodiment.

### EMBODIMENTS OF THE PRESENT DISCLOSURE

Described herein are electronic systems, and more particularly, electronic packages with spherical antenna arrangements with Z-dimensional plated antenna structures, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

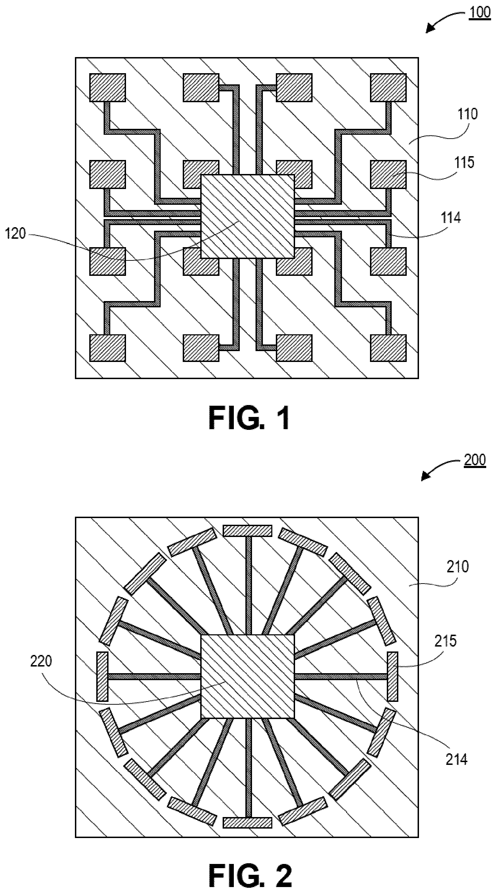

Referring now to Figure 1, a plan view illustration of an electronic package 100 is shown in order to provide context to embodiments described herein. The electronic package 100 may include a package substrate 110. The package substrate 110 may be an organic package substrate with (or without) a core. The package substrate 110 may also be a redistribution layer or include a redistribution layer. A die 120 may be provided on the package substrate 110. The die 120 may be a transceiver die. As shown, an array of antennas 115 is provided around the die 120. For example, a four-by-four array of antennas 115 is used in Figure 1. In Figure 1, the antennas 115 may be two-dimensional (2D) antenna architectures. As used herein, a 2D structure may be one with a length and width that both larger than a height. That is, a 2D structure may in fact have three dimensions, but the height dimension is smaller than the other dimensions. For example, the height dimension may be equal to a thickness of traces formed on the package substrate 110.

The antennas 115 may be communicatively coupled to the die 120 by traces 114. For example, the traces 114 may be copper traces or the like. However, due to the four-by-four array layout, the traces 114 may have non-uniform lengths. This leads to issues with communicating with external devices.

Accordingly, embodiments disclosed herein include an antenna architecture that has uniform (or substantially uniform) trace lengths between the die and the antennas. For example, the antennas may be provided in a ring around the die. Additionally, the antennas may be three-dimensional (3D) antennas. The use of 3D antennas allows for easier propagation of electromagnetic radiation in a plane parallel to the X-Y plane. 3D antennas may also be shaped in order to improve communications. For example, the 3D antennas may have curved or parabolic shapes in order to improve propagation of electromagnetic radiation signals. As such, extensive beam forming techniques are not needed for embodiments disclosed herein.

In some embodiments, the 3D antennas are provided on the package substrate, and the 3D antennas are coupled to a transceiver die through traces on the package substrate. In other embodiments, the 3D antennas may be fabricated directly on the transceiver die. A redistribution layer or other routing on the die may be coupled to the 3D antennas. In yet another embodiment, 3D isolation structures may be provided between antennas in order to minimize cross-talk between antennas.

Referring now to Figure 2, a plan view illustration of an electronic package 200 is shown, in accordance with an embodiment. In an embodiment, the electronic package 200 may comprise a package substrate 210. The package substrate 210 may be an organic package substrate, such as one comprising organic buildup film. The package substrate 210 may comprise a core or the package substrate 210 may be coreless. The package substrate 210 may also be a redistribution layer. While an organic package substrate 210 is described herein, it is to be appreciated that the antenna architecture may be provided over any substrate, such as an interposer (e.g., a silicon interposer, a glass interposer, an organic interposer, or the like).

In an embodiment, the electronic package 200 may comprise a die 220. The die 220 may be a transceiver die. That is, the die 220 may be configured to process electromagnetic signals that are to be propagated from the electronic package 200 or received by the electronic package 200. The die 220 may include any suitable semiconductor material. For example, the die 220 may comprise silicon or a group III-V semiconductor material.

In an embodiment, an array of antennas 215 may be provided around a perimeter of the die 220. For example, the array of antennas 215 may be provided in a ring or circle around the die 220. Though, the antennas 215 may be in other shaped rings (e.g., square, rectangular, or any other polygon) around the die 220. In an embodiment, the antennas 215 may be coupled to the die 220 through traces 214 that are provided on the package substrate 210. In an embodiment, the lengths of each of the traces 214 are substantially uniform. As used herein, substantially uniform lengths may refer to lengths that are within ten percent of each other. For example, a trace length of 90µm is substantially equal to a trace length of 100µm. It is to be appreciated that since the die 220 is rectangular and the antennas 215 are in a circle, the distances of all traces 214 may not be perfectly equal to each other. However, the differences between lengths of the traces 214 may only minimally affect signal propagation and signal reception. In an embodiment, a difference in the lengths of two traces 214 that are substantially equal to each other may be approximately 15µm or less, approximately 5µm or less, or approximately 1µm or less. As used herein, "approximately" may refer to a range within ten percent of the stated value. For example, approximately 1µm may refer to a range between 0.9µm and 1.1µm.

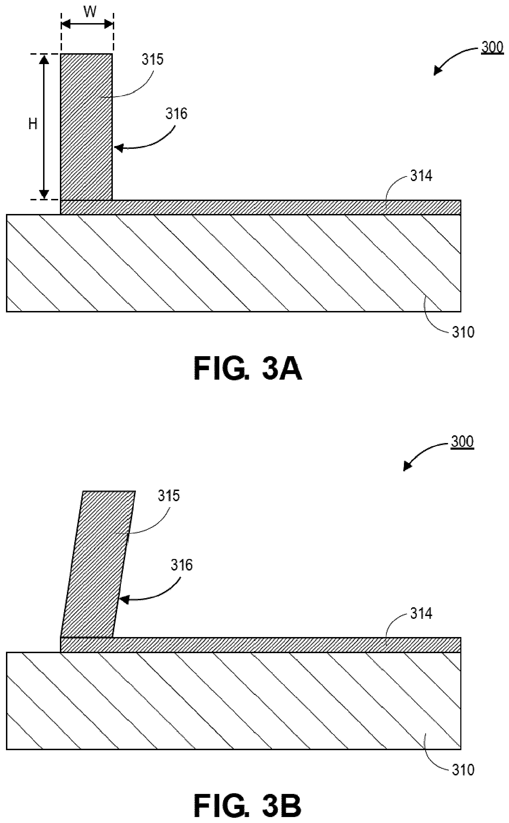

Referring now to Figure 3A, a cross-sectional illustration of a portion of an electronic package 300 is shown, in accordance with an embodiment. As shown, a trace 314 is provided over a top surface of the package substrate 310. The trace 314 may couple an antenna 315 to a die (not shown). In an embodiment, the antenna 315 may have a 3D shape. For example, the width W, height H, and length (into and out of the plane of Figure 3A) may be greater than a thickness of the trace 314. In a particular embodiment, the height H may be approximately 100µm or greater, approximately 500µm or greater, or approximately 1,000µm or greater. In an embodiment, the antenna 315 may have sidewalls 316 that are substantially vertical. Such an antenna structure may be fabricated using copper plating processes, as will be described in greater detail below.

Referring now to Figure 3B, a cross-sectional illustration of a portion of an electronic package 300 is shown, in accordance with an additional embodiment. The electronic package 300 in Figure 3B may be substantially similar to the electronic package 300 in Figure 3A with the exception of the shape of the antenna 315. Instead of having a rectangular cross-section, the antenna 315 in Figure 3B has a parallelogram cross-section. That is, sidewalls 316 may be non-vertical in some embodiments.

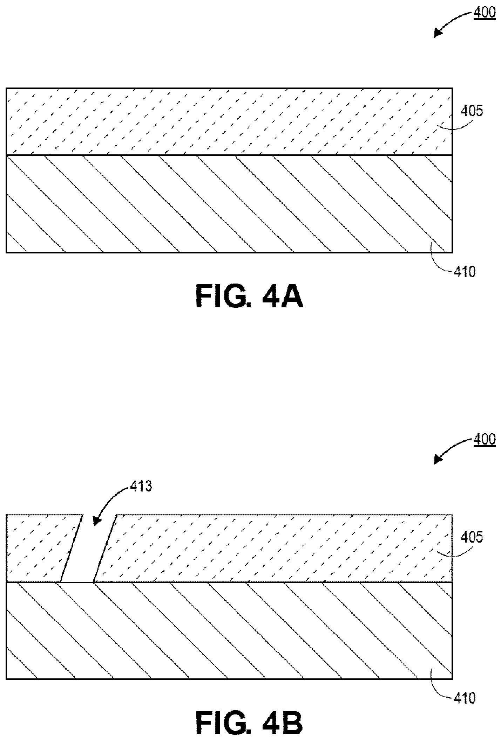

Referring now to Figures 4A-4F, a series of cross-sectional illustrations depicting a process for forming a 3D antenna structure is shown, in accordance with an embodiment. While a particular process flow is shown in Figures 4A-4F, it is to be appreciated that 3D antenna structures may be formed with other fabrication process, and embodiments are not limited to the process flow of Figures 4A-4F.

Referring now to Figure 4A, a cross-sectional illustration of an electronic package 400 at a stage of manufacture is shown, in accordance with an embodiment. In an embodiment, the electronic package 400 may comprise a package substrate 410. The package substrate 410 may be an organic package substrate, an interposer, or any other suitable substrate. The package substrate 410 may include a core, or the package substrate 410 may be coreless. In an embodiment, a first resist layer 405 may be provided over the package substrate 410. The first resist layer 405 may be a material that can be patterned with a photolithography process.

Referring now to Figure 4B, a cross-sectional illustration of the electronic package 400 after an opening 413 is provided in the first resist layer 405 is shown, in accordance with an embodiment. The opening 413 may be formed with any suitable lithography process. In a particular embodiment, the opening 413 may include sidewalls that are non-vertical. Such angled openings 413 may be formed with a laser direct imaging process. Of course, embodiments may include openings 413 that include substantially vertical sidewalls.

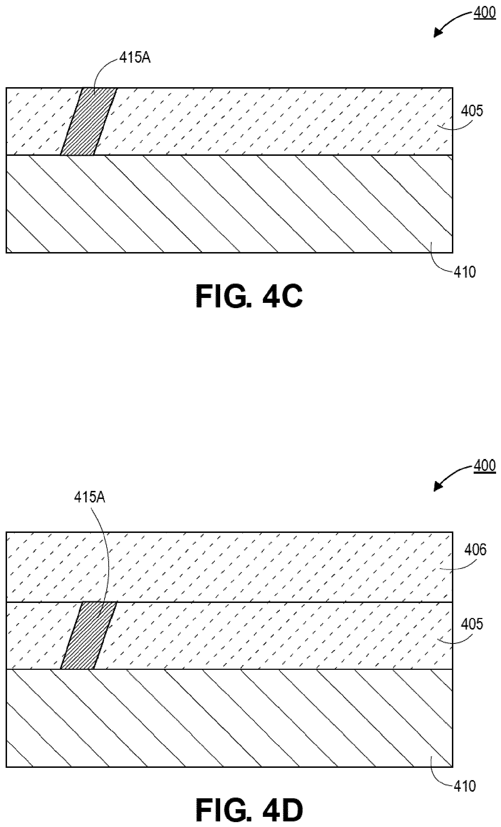

Referring now to Figure 4C, a cross-sectional illustration of the electronic package 400 after a plating process to form a first portion 415A of the antenna is shown, in accordance with an embodiment. In an embodiment, the first portion 415A may be plated with any suitable plating process, such as electrolytic plating or the like. While no seed layer is shown in Figure 4C, it is to be appreciated that seed layers may be used to plate up the first portion 415A, as is typical in electrolytic plating processes.

Referring now to Figure 4D, a cross-sectional illustration of the electronic package 400 after a second resist layer 406 is applied over the first resist layer 405 is shown, in accordance with an embodiment. In some embodiments, the second resist layer 406 may be the same material as the first resist layer 405. The second resist layer 406 may be applied with a lamination process, a spin coating process, or any other deposition process. A thickness of the second resist layer 406 may be substantially similar to the thickness of the first resist layer 405. Though, the second resist layer 406 may be thicker or thinner than the first resist layer 405.

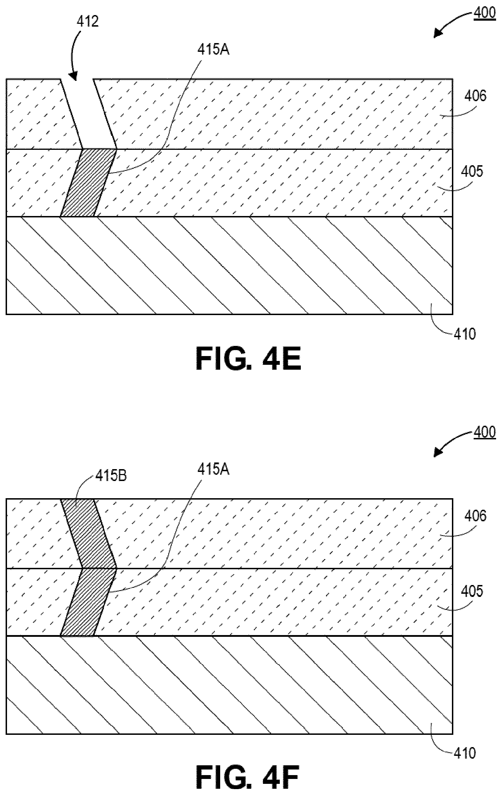

Referring now to Figure 4E, a cross-sectional illustration of the electronic package 400 after an opening 412 is formed in the second resist layer 406 is shown, in accordance with an embodiment. In an embodiment, the opening 412 may be formed with any suitable photolithography process. For example, a laser direct imaging process may be used to form a non-vertical opening 412. In an embodiment, a shape of the opening 412 may be a mirror image of the shape of the first portion 415A of the antenna.

Referring now to Figure 4F, a cross-sectional illustration of the electronic package 400 after a second portion 415B of the antenna is formed is shown, in accordance with an embodiment. In an embodiment, the second portion 415B of the antenna may be formed with a plating process, such as an electrolytic plating process. The second portion 415B of the antenna may be a mirror image of the first portion 415A of the antenna. As such, the combined antenna (i.e., first portion 415A and second portion 415B) may have a shape that opens up toward an edge of the electronic package 400. In some embodiments, the antenna 415 may have a parabolic shape, or a roughly parabolic shape. After the second portion 415B of the antenna is formed, the resist layers 405 and 406 may be removed. In some embodiments, a mold layer may subsequently be formed around the antenna 415.

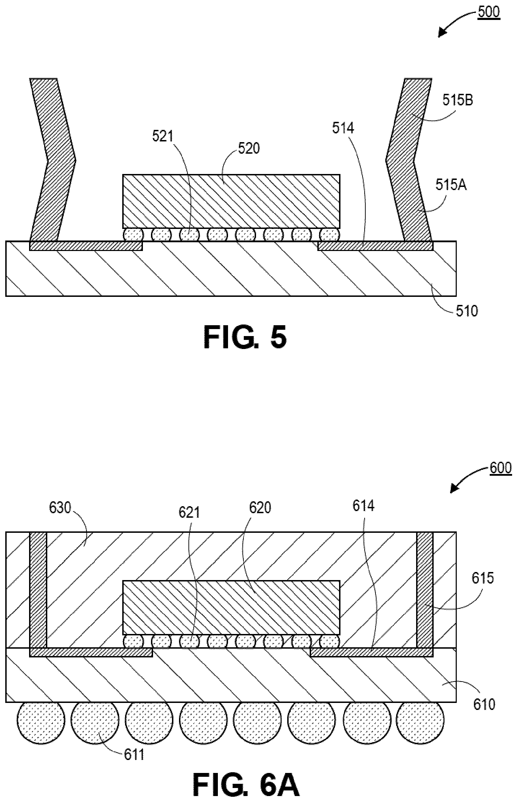

Referring now to Figure 5, a cross-sectional illustration of an electronic package 500 is shown, in accordance with an embodiment. In an embodiment, the electronic package 500 comprises a package substrate 510. The package substrate 510 may be similar to any of the package substrates described above. A die 520 may be coupled to the package substrate 510 through interconnects 521. The interconnects 521 may be solder balls, copper bumps, or any other first level interconnect (FLI) architecture. In an embodiment, the die 520 may be a transceiver die 520.

In an embodiment, the die 520 may be coupled to antennas 515 by traces 514 along a surface of the package substrate 510. The antennas 515 may be 3D features. For example, a height of the antennas 515 may be greater than a thickness of the traces 514. The height of the antennas 515 may be approximately 100µm or greater, approximately 500µm or greater, or approximately 1,000µm or greater.

In an embodiment, the antennas 515 may comprise a first portion 515A and a second portion 515B. The first portion 515A and the second portion 515B may have non-vertical sidewalls. For example, the first portion 515A and the second portion 515B may be parallelograms. The first portion 515A may be a mirror image of the second portion 515B. As shown, the antennas 515 are oriented so that they open out away from the die 520. The antennas 515 may have parabolic or near parabolic shapes.

Referring now to Figure 6A, a cross-sectional illustration of an electronic package 600 is shown, in accordance with an embodiment. The electronic package 600 may comprise a package substrate 610. In an embodiment, a die 620 is provided on a first side of the package substrate 610 and interconnects 611 are provided on a second side of the package substrate 610. The die 620 may be coupled to the package substrate 610 through interconnects 621. The die 620 may be a transceiver die 620 in some embodiments.

3D antennas 615 may be provided on the first side of the package substrate 610. The antennas 615 may be coupled to the die 620 through traces 614 provided on the package substrate 610. The antennas 615 may have a height that is greater than a thickness of the traces 614. For example, the antennas 615 may have a height that is approximately 100µm or greater, approximately 500µm or greater, or approximately 1,000µm or greater. In the illustrated embodiment, the antennas 615 have substantially vertical sidewalls. Though, in other embodiments, the antennas 615 may have sloped or otherwise non-vertical sidewalls. In an embodiment, the die 620 and the antennas 615 may be embedded in a mold layer 630.

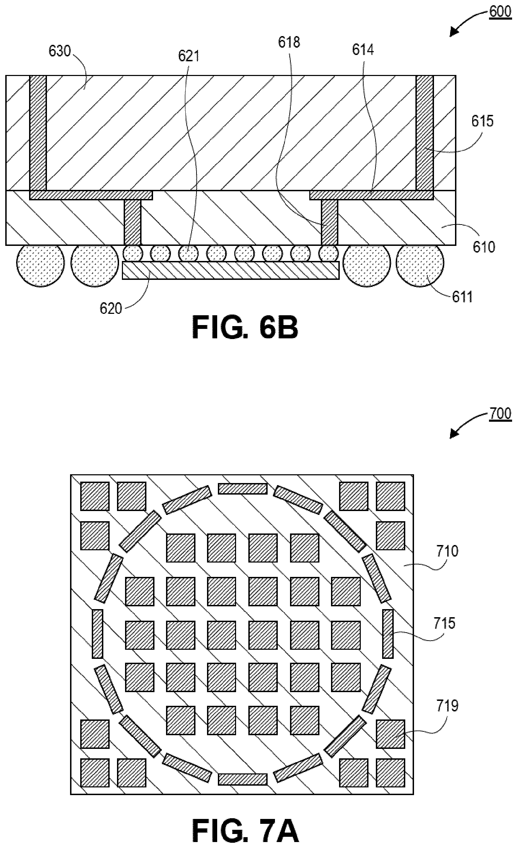

Referring now to Figure 6B, a cross-sectional illustration of an electronic package 600 is shown, in accordance with an additional embodiment. In an embodiment, the electronic package 600 may comprise a package substrate 610. Antennas 615 may be provided over a first surface of the package substrate 610. The antennas 615 may be 3D structures similar to any of the antennas described in greater detail herein. In an embodiment, a die 620 may be provided over a second surface of the package substrate 610 opposite from the first surface. The die 620 may be coupled to the package substrate through interconnects 621. Additionally interconnects 611 may also be provided over the second surface of the package substrate 610. In an embodiment, die 620 is coupled to traces 614 and antennas 615 through vias 618. The vias 618 may pass through a thickness of the package substrate 610.

Referring now to Figure 7A, a plan view illustration of an electronic package 700 is shown, in accordance with an additional embodiment. As shown, the electronic package 700 comprises a package substrate 710. In an embodiment, an array of antennas 715 and 719 are provided over a surface of the package substrate 710. In one embodiment, the antennas 715 are 3D structures. Further, the antennas 715 may be provided in a circle pattern on the package substrate 710. A die (not shown) may be provided at a center of the circle pattern (e.g., on the opposite side of the package substrate 710).

In an embodiment, antennas 719 may be provided in an array on the package substrate 710. The antennas 719 may be 2D structures. For example, the antennas 719 may be patch antennas in some embodiments. The antennas 719 may be provided within the circle pattern of the antennas 715 and outside of the circle pattern of the antennas 715. As such, embodiments disclosed herein provide the inclusion of both 3D and 2D antenna structures on the same package substrate 710.

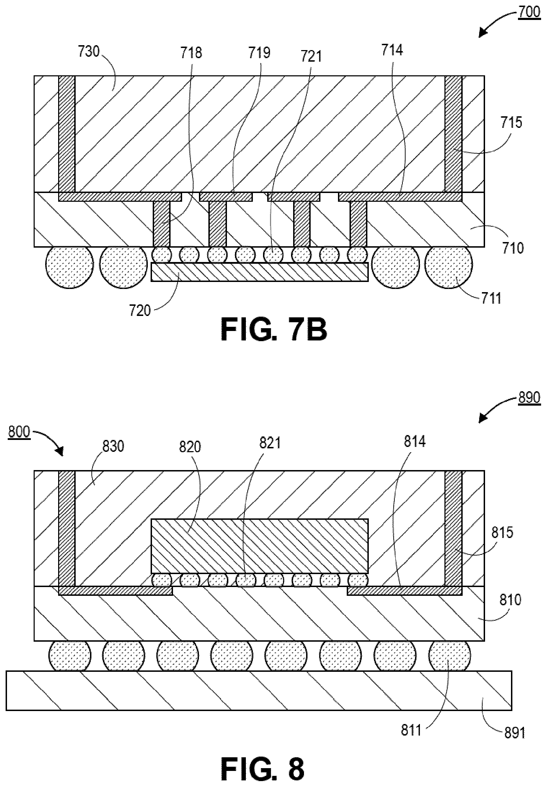

Referring now to Figure 7B, a cross-sectional illustration of the package substrate 700 is shown, in accordance with an embodiment. As shown, a die 720 with interconnects 721 is provided on the bottom surface of the package substrate 710. Interconnects 711 may also be provided on the bottom surface of the package substrate 710. In an embodiment, vias 718 through the package substrate 710 may communicatively couple the die 720 to the antennas 715 and 719. Traces 714 may couple the vias 718 to the antennas 715. The antennas 715 may be 3D structures and the antennas 719 may be 2D structures. For example, a height of antennas 715 is greater than a height of the antennas 719. In an embodiment, a mold layer 730 may be provided over the top surface of the package substrate 710 in order to embed the antennas 715 and 719.

Referring now to Figure 8, a cross-sectional illustration of an electronic system 890 is shown, in accordance with an embodiment. In an embodiment, the electronic system 890 comprises a board 891, such as a printed circuit board (PCB). An electronic package 800 is coupled to the board 891 through interconnects 811. The interconnects 811 may be any second level interconnect (SLI) architecture. For example, the interconnects 811 may be solder balls, sockets, or the like.

In an embodiment, the electronic package 800 comprises a package substrate 810. A die 820 and antennas 815 are provided on a top surface of the package substrate 810. The die 820 may be coupled to the package substrate 810 through interconnects 821. The die 820 may be a transceiver die 820. The antennas 815 may be coupled to the die 820 through traces 814. The antennas 815 may be 3D structures. For example, a height of the antennas 815 may be greater than a thickness of the traces 814. The antennas 815 may be similar to any of the 3D antennas described in greater detail herein. The die 820 and the antennas 815 may be embedded in a mold layer 830.

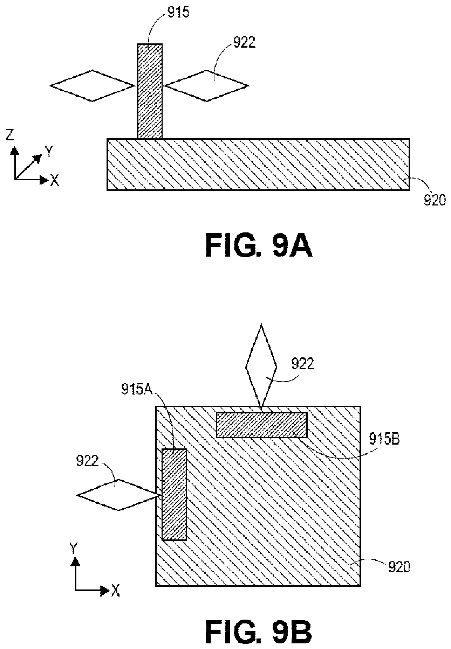

In addition to forming 3D antennas on a package substrate, embodiments also include the formation of 3D antennas directly on the die. Such embodiments are shown and described with respect to Figures 9A-12.

Referring now to Figure 9A, a cross-sectional illustration of a die 920 is shown, in accordance with an embodiment. In an embodiment, the die 920 may be a transceiver die 920. In an embodiment, a 3D antenna 915 may be provided over a top surface of the die 920. The antenna 915 may have a height that is approximately 100µm or greater, approximately 500µm or greater, or approximately 1,000µm or greater. The antenna 915 may be formed with any suitable patterning process. For example a process similar to the one described above with respect to Figure 4A-4F may be used to form the antenna 915. As shown, the antenna 915 may be configured to propagate electromagnetic radiation 922 in a direction parallel to the X-Y plane.

Referring now to Figure 9B, a plan view illustration of a die 920 is shown, in accordance with an additional embodiment. In the illustrated embodiment, a pair of antennas 915A and 915B are provided on the die 920. The antennas 915A and 915B may be 3D antenna structures. The antennas 915 may be oriented in order to propagate electromagnetic radiation 922 in different directions. For example, antenna 915A propagates electromagnetic radiation 922 in the X-direction, and antenna 915B propagates electromagnetic radiation 922 in the Y-direction.

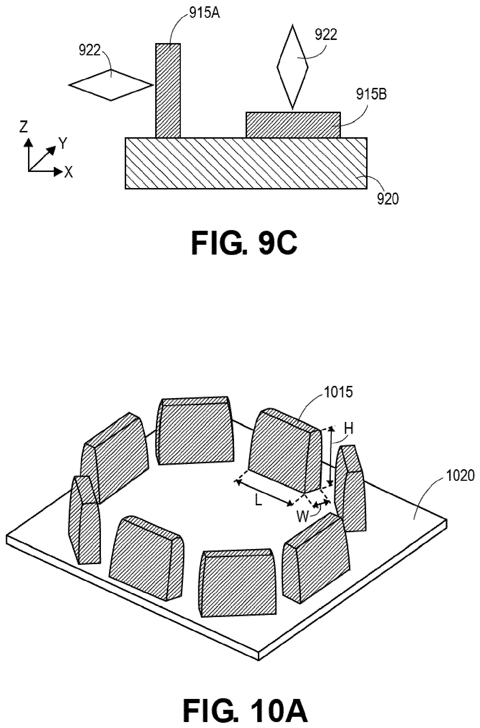

Referring now to Figure 9C, a cross-sectional illustration of a die 920 is shown, in accordance with an additional embodiment. As shown, a first antenna 915A and a second antenna 915B are provided on a top surface of the die 920. The first antenna 915A may be a 3D antenna. The first antenna 915A may propagate electromagnetic radiation 922 in the X-direction in a plane parallel to the X-Y plane. The second antenna 915B may be a 2D antenna. For example, the second antenna 915B may be a patch antenna. The second antenna 915B may propagate electromagnetic radiation 922 in the Z-direction.

Referring now to Figures 10A-10D, a series of illustrations depicting dies 1020 with 3D antenna structures are shown, in accordance with various embodiments.

Referring now to Figure 10A, an illustration of a die 1020 with overlying 3D antennas 1015 is shown, in accordance with an embodiment. The antennas 1015 may be provided in a circular pattern around the top surface of the die 1020. The antennas 1015 may have a length L, a width W, and a height H. In an embodiment, the height H is greater than one or both of the length L and the width W. For example, the height H may be approximately 100µm or greater, approximately 500µm or greater, or approximately 1,000µm or greater. The antennas 1015 may be referred to as being wall segments in some embodiments. While shown in a circular pattern, it is to be appreciated that the antennas 1015 may be provided in any pattern over the die 1020.

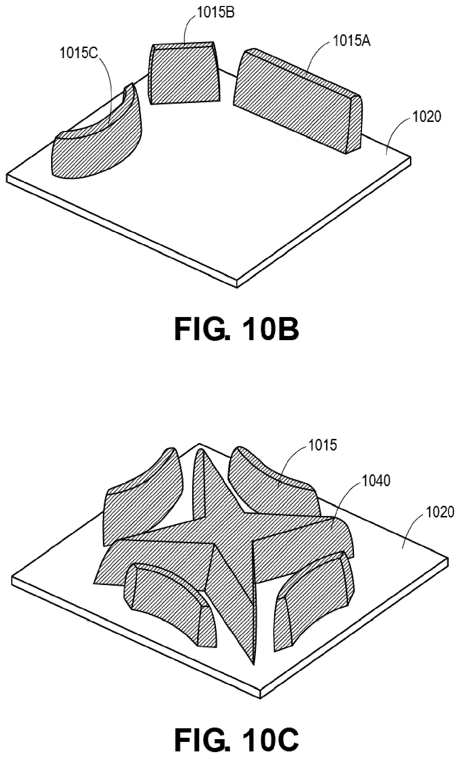

Referring now to Figure 10B, an illustration of a die 1020 with a different antenna 1015 configuration is shown, in accordance with an embodiment. In the embodiment shown in Figure 10B, the antennas 1015 may have different shapes. For example, antenna 1015A may be a long wall, antenna 1015B may be a short wall, and antenna 1015C may be curved. For example, the curve of antenna 1015C may be parabolic in some embodiments.

Referring now to Figure 10C, an illustration of a die 1020 with isolated antennas 1015 is shown, in accordance with an embodiment. For example, an isolation structure 1040 may be provided between the antennas 1015. The isolation structure 1040 may be an electrically conductive structure that is grounded. As such, cross-talk between the antennas 1015 may be mitigated. In the particular embodiment, the isolation structure 1040 has a star shape. Though different shapes may also be used. In an embodiment, the antennas 1015 are curved. Though, wall shaped antennas may also be included in some embodiments.

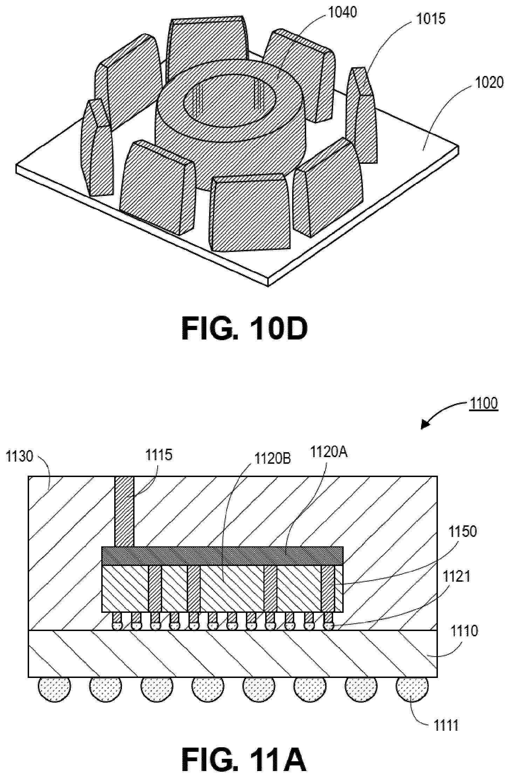

Referring now to Figure 10D, an illustration of a die 1020 with isolated antennas 1015 is shown, in accordance with an additional embodiment. In Figure 10D, the antennas 1015 are wall antennas 1015 that form a circular pattern. In an embodiment, the isolation structure 1040 may be a conductive ring that is provided inside the circular pattern. While wall antennas 1015 are shown, it is to be appreciated that curved antennas 1015 may also be used in some embodiments.

Referring now to Figure 11A, a cross-sectional illustration of an electronic package 1100 is shown, in accordance with an embodiment. In an embodiment, the electronic package 1100 may include a package substrate 1110. The package substrate 1110 may include interconnects 1111 on a bottom surface and a die 1120 on a top surface. The die 1120 may be coupled to the package substrate through interconnects 1121. In an embodiment, the die 1120 may have an active layer 1120A and substrate 1120B. The active layer 1120A may include transistors and other functional circuitry. Vias (e.g., through silicon vias (TSVs)) 1150 may be provided through the substrate 1120B.

In an embodiment, a 3D antenna 1115 may be provided over the die 1120. The 3D antenna 1115 may be a wall antenna, a curved antenna, or any other antenna structure similar to those described in greater detail herein. While a single 3D antenna 1115 is shown in Figure 11A, it is to be appreciated that an array of 3D antennas 1115 may be provided on the surface of the die 1120. In an embodiment, a mold layer 1130 may be provided over the package substrate 1110 in order to embed the die 1120 and the 3D antenna 1115.

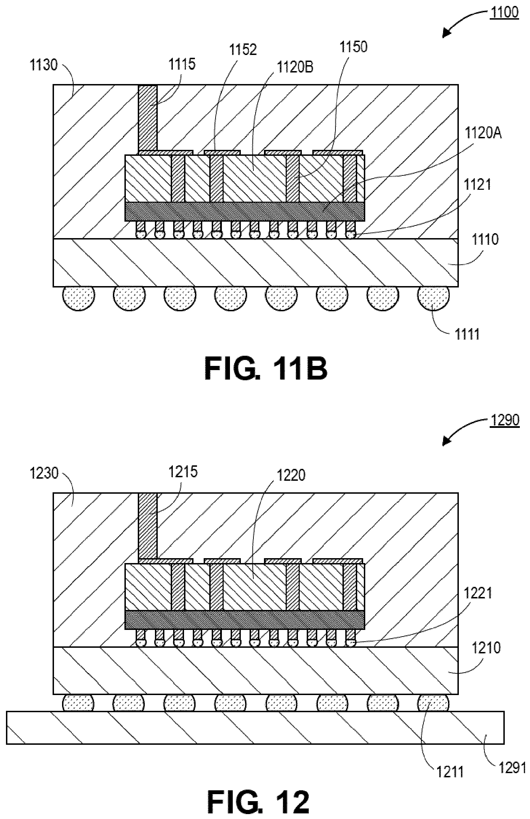

Referring now to Figure 11B, a cross-sectional illustration of an electronic package 1100 is shown, in accordance with an additional embodiment. As shown, the active region 1120A is provided at a bottom with the substrate 1120B over the active region 1120A. In an embodiment a redistribution layer 1152 may be provided over a top surface of the die 1120. The redistribution layer 1152 may couple TSVs 1150 to the 3D antenna 1115.

Referring now to Figure 12, a cross-sectional illustration of an electronic system 1290 is shown, in accordance with an embodiment. In an embodiment, the electronic system 1290 comprises a board 1291, such as a PCB. The board 1291 may be coupled to a package substrate 1210 through interconnects 1211. The interconnects 1211 may be solder balls, sockets, or any other SLI architecture. In an embodiment, a die 1220 is coupled to the package substrate 1210 through interconnects 1221. The interconnects 1221 may be any FLI architecture. In an embodiment, a 3D antenna 1215 is provided over the die 1220. The 3D antenna 1215 may be similar to any of the 3D antenna structures described herein. Further, an array of 3D antennas 1215 may also be provided over the die 1220 in some embodiments. A mold layer 1230 may be provided over the package substrate 1210 to embed the die 1220 and the 3D antenna 1215.

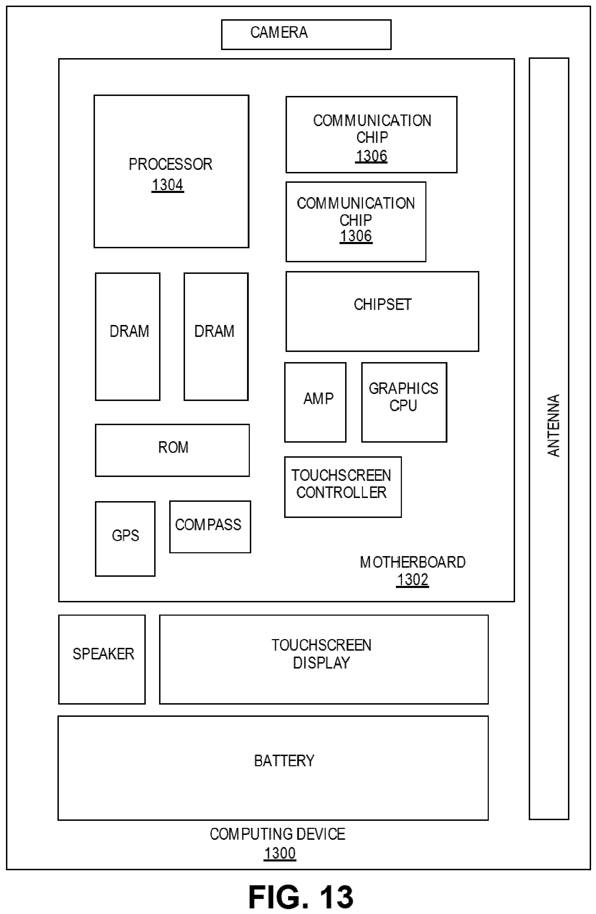

Figure 13 illustrates a computing device 1300 in accordance with one implementation of the invention. The computing device 1300 houses a board 1302. The board 1302 may include a number of components, including but not limited to a processor 1304 and at least one communication chip 1306. The processor 1304 is physically and electrically coupled to the board 1302. In some implementations the at least one communication chip 1306 is also physically and electrically coupled to the board 1302. In further implementations, the communication chip 1306 is part of the processor 1304.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1306 enables wireless communications for the transfer of data to and from the computing device 1300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1306 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1300 may include a plurality of communication chips 1306. For instance, a first communication chip 1306 may be dedicated to shorter range wireless communications such as Wi-Fi and Bluetooth and a second communication chip 1306 may be dedicated to longer range wireless communications such as GPS, EDGE, GPRS, CDMA, WiMAX, LTE, Ev-DO, and others.

The processor 1304 of the computing device 1300 includes an integrated circuit die packaged within the processor 1304. In some implementations of the invention, the integrated circuit die of the processor may be part of an electronic package with a 3D antenna structure over a package substrate or over the integrated circuit die, in accordance with embodiments described herein. The term "processor" may refer to any device or portion of a device that processes electronic data from registers and/or memory to transform that electronic data into other electronic data that may be stored in registers and/or memory.

The communication chip 1306 also includes an integrated circuit die packaged within the communication chip 1306. In accordance with another implementation of the invention, the integrated circuit die of the communication chip may be part of electronic package with a 3D antenna structure over a package substrate or over the integrated circuit die, in accordance with embodiments described herein.

In an embodiment, the computing device 1300 may be part of any apparatus. For example, the computing device may be part of a personal computer, a server, a mobile device, a tablet, an automobile, or the like. That is, the computing device 1300 is not limited to being used for any particular type of system, and the computing device 1300 may be included in any apparatus that may benefit from computing functionality.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a communication module, comprising, comprising: a package substrate; a die on the package substrate; and a plurality of antennas around the die, wherein the plurality of antennas are coupled to the die by a plurality of traces, and wherein heights of each of the plurality of antennas is greater than a thickness of the traces.

Example 2: the communication module of Example 1, wherein the plurality of traces have substantially uniform lengths.

Example 3: the communication module of Example 1 or Example 2, wherein the plurality of antennas are in a circular arrangement around the die.

Example 4: the communication module of Examples 1-3, wherein the heights of each of the plurality of antennas is greater than a length and/or a width of each of the plurality of antennas.

Example 5: the communication module of Examples 1-4, wherein the height is approximately 100µm or taller.

Example 6: the communication module of Examples 1-5, wherein the plurality of antennas have non-vertical sidewalls.

Example 7: the communication module of Example 6, wherein the plurality of antennas have a first portion that is angled in towards the die and a second portion that is angled away from the die.

Example 8: the communication module of Examples 1-7, wherein one or more of the plurality of antennas have parabolic surfaces.

Example 9: the communication module of Examples 1-8, further comprising planar antennas on a surface of the package substrate.

Example 10: the communication module of Examples 1-9, wherein the die is on an opposite side of the package substrate from the plurality of antennas.

Example 11: a communication die, comprising: a die, wherein the die comprises a semiconductor substrate; an antenna on the die, wherein the antenna has a length, a width, and a height, wherein the height is greater than one or both of the length and the width.

Example 12: the communication die of Example 11, wherein the antenna is curved.

Example 13: the communication die of Example 11 or Example 12, wherein the height is approximately 100µm or greater.

Example 14: the communication die of Examples 11-13, wherein the length and the height are greater than the width.

Example 15: the communication die of Example 14, wherein the antenna is a wall.

Example 16: the communication die of Examples 11-15, further comprising: a plurality of antennas on the die.

Example 17: the communication die of Example 16, further comprising: a three dimensional electrically conductive shape between the antenna and the plurality of antennas.

Example 18: an electronic system, comprising: a board; a package substrate coupled to the board; a die coupled to the package substrate, wherein the die is a transceiver; and an antenna coupled to the die, wherein the antenna is a three-dimensional shape.

Example 19: the electronic system of Example 18, wherein the antenna is on the die, or wherein the antenna is on the package substrate.

Example 20: the electronic system of Example 18 or Example 19, wherein the electronic system is part of a personal computer, a server, a mobile device, a tablet, or an automobile.

## Claims

1. A communication module, comprising:
a package substrate;
a die on the package substrate; and
a plurality of antennas around the die, wherein the plurality of antennas are coupled to the die by a plurality of traces, and wherein heights of each of the plurality of antennas is greater than a thickness of the traces.

2. The communication module of claim 1, wherein the plurality of traces have substantially uniform lengths.

3. The communication module of claim 1 or 2, wherein the plurality of antennas are in a circular arrangement around the die.

4. The communication module of claim 1, 2 or 3, wherein the heights of each of the plurality of antennas is greater than a length and/or a width of each of the plurality of antennas.

5. The communication module of claim 1, 2, 3 or 4, wherein the height is approximately 100µm or taller.

6. The communication module of claim 1, 2, 3, 4 or 5, wherein the plurality of antennas have non-vertical sidewalls.

7. The communication module of claim 6, wherein the plurality of antennas have a first portion that is angled in towards the die and a second portion that is angled away from the die.

8. The communication module of claim 1, 2, 3, 4, 5, 6 or 7, wherein one or more of the plurality of antennas have parabolic surfaces.

9. The communication module of claim 1, 2, 3, 4, 5, 6, 7 or 8, further comprising planar antennas on a surface of the package substrate.

10. The communication module of claim 1, 2, 3, 4, 5, 6, 7, 8 or 9, wherein the die is on an opposite side of the package substrate from the plurality of antennas.

11. A method of fabricating a communication module, the method comprising:
forming a package substrate;
providing a die on the package substrate; and
forming a plurality of antennas around the die, wherein the plurality of antennas are coupled to the die by a plurality of traces, and wherein heights of each of the plurality of antennas is greater than a thickness of the traces.

12. The method of claim 11, wherein the plurality of traces have substantially uniform lengths.

13. The method of claim 11 or 12, wherein the plurality of antennas are in a circular arrangement around the die.

14. The method of claim 11, 12 or 13, wherein the heights of each of the plurality of antennas is greater than a length and/or a width of each of the plurality of antennas.

15. The method of claim 11, 12, 13 or 14, wherein the height is approximately 100µm or taller.
